# EUROPÄISCHE PATENTANMELDUNG

(11) **EP 0 833 391 A1**
(43) Veröffentlichungstag der Anmeldung: **01.04.1998**
(21) Anmeldenummer: 97114482.9
(22) Anmeldetag: 21.08.1997
(51) Int. Cl.: H01L 29/76, H01L 29/06, H01S 3/025

(54) **Halbleitervorrichtung auf III-V Halbleitersubstrat und Verfahren zu dessen Herstellung**

(30) Priorität: 27.09.1996 DE 19640003
(71) Anmelder: SIEMENS AKTIENGESELLSCHAFT, 80333 München (DE)
(72) Erfinder: Lell, Alfred, Dipl.-Phys., 93142 Maxhütte-Haidhof (DE)

(57) **Zusammenfassung**

Halbleitervorrichtung, bei der eine funktionelle HL-Struktur auf einem III-V-Halbleiter-Substrat (3) angeordnet ist. Es ist ein elektrisch leitendes III-V-Halbleiter-Substrat (3) eines ersten Leitungstyps vorgesehen, das bei Raumtemperatur eine Ladungsträgerkonzentration von größer als 1*10¹⁵ cm⁻³ aufweist. Zwischen der funktionellen Halbleiterstruktur (1) und dem III-V-Halbleiter-Substrat (3) ist mindestens ein im Betrieb der Halbleitervorrichtung sperrend gepolter pn-Übergang vorgesehen.

## Beschreibung

Die Erfindung bezieht sich auf eine Halbleitervorrichtung, bei dem einer ersten Hauptfläche eines III-V-Halbleiter-Substrats mindestens eine funktionelle Halbleiterstruktur zugeordnet ist und bei dem die funktionelle Halbleiterstruktur von einer der ersten Hauptfläche gegenüberliegenden zweiten Hauptfläche des III-V-Halbleiter-Substrats elektrisch isoliert ist.

Eine derartige Halbleitervorrichtung ist beispielsweise aus Franklin S. Harris, Jr., Applied Optics, Vol. 27, No. 15, page 3141, bekannt. Hierin ist ein Fotodioden-Array beschrieben, bei dem auf einem sogenannten semiisolierenden GaAs-Substrat eine Mehrzahl von AlGaAs/GaAs-Fotodioden monolithisch integriert sind.

Weiterhin ist aus G. Müller, M. Honsberg, Journal of Optical Communications 6 (1985), June No. 2, Berlin, Germany, page 42, eine MCRW-Laserstruktur bekannt, die auf einem semiisolierenden GaAs-Substrat aufgebracht ist. Das semiisolierende GaAs-Substrat dient hier dazu, mehrere auf dem Substrat monolithisch integrierte Komponenten voneinander elektrisch zu isolieren.

Die Isolationswirkung von semiisolierenden Substraten wird über den Einbau tiefer Störstellen-Niveaus (z.B. Cr bzw. C bei GaAs-Substraten und Fe bei InP-Substraten) erreicht. Der Einbau derartiger Dotierstoffe in ein III-V-Kristallgitter bringt jedoch sowohl in der Herstellung als auch in der Handhabung eine Reihe von Schwierigkeiten mit sich. So ist es beispielsweise sehr schwierig, diese Dotierstoffe homogen in das III-V-Kristallgitter einzubauen, wodurch die Realisierung einer homogenen Isolationswirkung über die gesamte Fläche eines semiisolierenden Substrats erheblich erschwert ist. Die Produktionsausbeute von Halbleiterbauelementen mit semiisolierenden Substraten ist daher z. B. im Vergleich zur Herstellung von Halbleiterbauelementen auf leitenden GaAs-Substraten sehr gering.

Ein weiteres Problem von semiisolierenden Halbleitersubstraten besteht darin, daß ihre Isolationswirkung schon bei mäßiger Temperaturerhöhung drastisch abnimmt, da im Halbleiterkristall freie Ladungsträger erzeugt werden.

Der vorliegenden Erfindung liegt die Aufgabe zugrunde, eine Halbleitervorrichtung der eingangs genannten Art zu entwickeln, bei dem die elektrischen Isolationseigenschaften zwischen der funktionellen Halbleiterstruktur und der zweiten Hauptfläche des III-V-Halbleiter-Substrats möglichst geringen Schwankungen unterworfen sind und bei dem die entsprechende elektrische Isolationswirkung auch bei üblicherweise im Betrieb von Halbleiterbauelementen auftretenden Temperaturerhöhungen, wie sie z. B. insbesondere bei Leistungshalbleiterbauelementen sowie in Kraftfahrzeugen (Umgebungstemperaturschwankungen) vorkommen, ausreichend groß ist.

Diese Aufgabe wird durch eine Halbleitervorrichtung mit den Merkmalen des Patentanspruches 1 gelöst. Vorteilhafte Weiterbildungen und bevorzugte Ausführungsformen der erfindungsgemäßen Halbleitervorrichtung sind Gegenstand der Unteransprüche 2 bis 10. Ein bevorzugtes Verfahren zum Herstellen einer erfindungsgemäßen Halbleitervorrichtung ist Gegenstand des Anspruches 11.

Erfindungsgemäß ist bei einer Halbleitervorrichtung der eingangs genannten Art ein elektrisch leitendes III-V-Halbleiter-Substrat vorgesehen und ist zwischen der funktionellen Halbleiterstruktur und dem III-V-Halbleiter-Substrat mindestens ein im Betrieb der Halbleitervorrichtung sperrend gepolter pn-Übergang angeordnet. Dies hat insbesondere den Vorteil, daß anstelle eines aufwendig herzustellenden semiisolierenden Substrates ein wesentlich einfacher herstellbares und damit kostengünstigeres leitendes Substrat verwendet werden kann. Die elektrische Isolation der funktionellen Halbleiterstruktur von der zweiten Hauptfläche des III-V-Halbleiter-Substrats übernimmt der im Betrieb sperrend gepolte pn-Übergang.

Bei einer bevorzugten Weiterbildung der erfindungsgemäßen Halbleitervorrichtung weist das elektrisch leitende III-V-Halbleiter-Substrat bei Raumtemperatur (d. h. bei ca. 20°C) eine Ladungsträgerkonzentration von > 1 · 10¹⁵ cm⁻³ auf. Besonders vorteilhaft ist, wenn das elektrisch leitende III-V-Halbleiter-Substrat bei Raumtemperatur eine Ladungsträgerkonzentration zwischen 1 ·10¹⁶ cm⁻³ und 1 · 10¹⁹ cm⁻³ aufweist. Derartige III-V-Halbleiter-Substrate werden für herkömmliche III-V-Halbleiter-Bauelemente in großen Stückzahlen hergestellt und sind von daher kostengünstig verfügbar.

Bei einer vorteilhaften Ausgestaltung der erfindungsgemäßen Halbleitervorrichtung ist ein dotiertes III-V-Halbleiter-Substrat eines ersten Leitungstyps vorgesehen. Auf diesem ist eine erste dotierte III-V-Halbleiterschicht eines zweiten Leitungstyps aufgebracht, auf der wiederum eine zweite dotierte III-V-Halbleiterschicht vom ersten Leitungstyp aufgebracht ist. Auf der zweiten dotierten III-V-Halbleiterschicht ist die funktionelle Halbleiterstruktur angeordnet. Das III-V-Halbleiter-Substrat, die erste und die zweite dotierte III-V-Halbleiterschicht bilden zusammen zwei entgegengesetzt gerichtete pn-Übergänge aus. Mit einer derartigen Schichtenfolge ist unabhängig davon, welchen Leitungstyp eine auf die zweite dotierte III-V-Halbleiterschicht aufgebrachte Halbleiterschicht der funktionelle Halbleiterstruktur aufweist, im Betrieb auf jeden Fall einer der beiden pn-Übergänge sperrend gepolt.

Bei einer weiteren bevorzugten Weiterbildung der erfindungsgemäßen Halbleitervorrichtung sind dem elektrisch leitenden III-V-Halbleitersubstrat mindestens zwei monolithisch integrierte funktionelle Halbleiterstrukturen zugeordnet und ist zwischen jeder der funktionellen Halbleiterstrukturen und dem elektrisch leitenden III-V-Halbleitersubstrat mindestens ein im Betrieb der Halbleitervorrichtung sperrend gepolter pn-Übergang angeordnet. Der pn-Übergang oder die pn-Übergänge ist bzw. sind in einem Zwischenraum zwischen den funktionellen Halbleiterstrukturen derart durchtrennt, daß über das III-V-Halbleitersubstrat einschließlich ggf. einer oder mehrerer darauf aufgebrachter III-V-Halbleiterschichten keine elektrisch leitende Verbindung zwischen den funktionellen Halbleiterstrukturen besteht. Dies ist dann der Fall, wenn der Strompfad zwischen zwei funktionellen Halbleiterstrukturen über einen sperrend gepolten pn-Übergang führen würde. Mit einer derartigen Halbleitervorrichtung ist es möglich, eine integrierte Schaltungsanordnung, bestehend aus einer Mehrzahl von III-V-Halbleiterbauelementen auf einem einzigen III-V-Halbleitersubstrat, auf einfache Weise zu realisieren.

Bei einem bevorzugten Verfahren zum Herstellen einer erfindungsgemäßen Halbleitervorrichtung wird auf ein vorgefertigtes dotiertes III-V-Halbleitersubstrat vom ersten Leitungstyp eine erste dotierte III-V-Halbleiterschicht vom zweiten Leitungstyp aufgebracht. Auf die erste dotierte III-V-Halbleiterschicht oder auf eine zusätzlich auf die erste dotierte III-V-Halbleiterschicht aufgebrachte zweite dotierte III-V-Halbleiterschicht vom ersten Leitungstyp wird dann ein aktives Schichtensystem mindesten einer funktionellen Halbleiterstruktur aufgebracht. Nachfolgend werden mittels Durchtrennen (z. B. Trennätzen oder Ansägen) des aktiven Schichtensystems einschließlich der ersten und ggf. der zweiten dotierten III-V-Halbleiterschicht mindestens zwei elektrisch voneinander isolierte funktionelle Halbleiterstrukturen hergestellt. Diese können dann mittels Kontaktmetallisierungen elektrisch miteinander verschaltet und ggf. an extern angeordnete weitere Bauelemente angeschlossen werden.

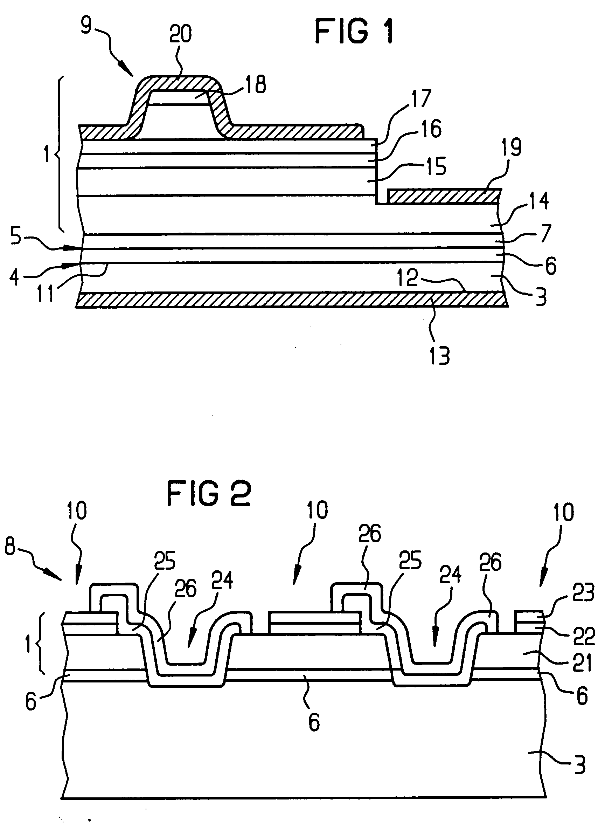

Die erfindungsgemäße Halbleitervorrichtung wird im weiteren anhand von zwei Ausführungsbeispielen in Verbindung mit den Figuren 1 und 2 näher erläutert. Es zeigen:
- Figur 1: eine schematische Darstellung einer Schnittansicht eines ersten Ausführungsbeispieles der erfindungsgemäßen Halbleitervorrichtung und
- Figur 2: eine schematische Schnittansicht eines zweiten Ausführungsbeispieles einer erfindungsgemäßen Halbleitervorrichtung.

Bei der funktionellen Halbleiterstruktur 1 von Figur 1 handelt es sich um eine MCRW-Laserstruktur 9. Diese ist auf einer Schichtenfolge aufgebracht, die aus einem III-V-Halbleitersubstrat 3 und einer auf diesem aufgebrachten ersten dotierten III-V-Halbleiterschicht 6, auf der wiederum eine zweite dotierte III-V-Halbleiterschicht 7 aufgebracht ist, besteht. Das III-V-Halbleitersubstrat 3 ist beispielsweise aus n-dotiertem GaAs hergestellt und die erste 6 und zweite 7 dotierte III-V-Halbleiterschicht besteht beispielsweise aus p-dotiertem bzw. n-dotiertem GaAs. Das III-V-Halbleitersubstrat 3 und die erste 6 und zweite 7 dotierte III-V-Halbleiterschicht bilden zwei entgegengesetzt gerichtete pn-Übergänge 4, 5 aus. Auf der einer ersten Hauptfläche 11 des III-V-Halbleitersubstrats 3 - dies ist die Fläche, auf der die erste dotierte III-V-Halbleiterschicht aufgebracht ist - gegenüberliegenden zweiten Hauptfläche 12 ist eine Metallisierungsschicht 13, z. B. bestehend aus Cr/In, aufgebracht. Diese dient beispielsweise dazu, die Halbleitervorrichtung auf eine aus Kupfer gefertigte Wärmesenke aufzulöten. Als Dotierstoffe für das III-V-Halbleiterstubstrat 3 und die erste 6 und zweite 7 dotierte III-V-Halbleiterschicht sind z. B. die in der Halbleitertechnik üblicherweise für III-V-Halbleitermateralien eingesetzten Dotierstoffe verwendet. Diese werden daher an dieser Stelle nicht näher erläutert.

Auf die zweite dotierte III-V-Halbleiterschicht ist die funktionelle Halbleiterstruktur 1 der MCRW-Laserstruktur 9 beispielsweise mittels MOVPE oder MBE aufgebracht. Diese besteht beispielsweise, ausgehend von der zweiten dotierten III-V-Halbleiterschicht 7, aus einer n⁺-dotierten GaAs-Schicht 14, einer n-dotierten GaAlAs-Schicht 15, einer aktiven Schicht 16 aus undotiertem GaAs oder aus einer/m aktiven Schichtenfolge/-system, einer p-dotierten GaAlAs-Schicht 17 und einer p⁺-dotierten GaAs-Schicht 18. Die n⁺-dotierte GaAs-Schicht 14 ist beispielsweise mit einem aus AuGe/Ni/Au bestehenden n-Kontakt 19 und die p-dotierte GaAlAs-Schicht 17 sowie die p⁺-dotierte GaAs-Schicht 18 ist mit einer p-Kontaktmetallisierung 20, die z. B. aus einer Cr/Au-, Cr/Pt/Au-, Ti/Pt/Au- oder Ti/Au-Schichtenfolge besteht, versehen. Hierbei handelt es sich um eine herkömmliche, dem Fachmann bekannte Struktur eines MCRW-Lasers, die von daher an dieser Stelle keiner näheren Erläuterung bedarf.

Selbstverständlich können auf einem III-V-Halbleitersubstrat 3 mit einer ersten 6 und einer zweiten 7 dotierten III-V-Halbleiterschicht gemäß dem ersten Ausführungsbeispiel mehrere MCRW-Laserstrukturen 9 ausgebildet sein, die voneinander elektrisch isoliert sind. Hierbei ist ausschließlich die elektrische Isolation durch das Substrat gemeint. Über Metallisierungsbahnen können die einzelnen MCRW-Lasterstrukturen natürlich untereinander verschaltet sein.

In Figur 2 ist ein Ausführungsbeispiel einer erfindungsgemäßen Halbleitervorrichtung dargestellt, bei der eine Mehrzahl von Fotodiodenstrukturen 10 eines Fotodiodenfeldes 8 auf einem einzigen elektrisch leitenden III-V-Halbleitersubstrat 3 eines ersten Leitungstyps aufgebracht sind. Zwischen den Fotodiodenstrukturen 10 und dem elektrisch leitenden III-V-Halbleitersubstrat 3, das beispielsweise aus n-dotiertem GaAs besteht, ist jeweils eine erste dotierte III-V-Halbleiterschicht 6 eines zweiten Leitungstyps angeordnet. Diese besteht z. B. aus p-dotiertem GaAs. Die Fotodiodenstrukturen 10 setzen sich ausgehend von der ersten dotierten III-V-Halbleiterschicht 6 jeweils aus einer n-dotierten GaAs-Schicht 21, einer p-dotierten GaAs-Schicht 22 und einer p-dotierten AlGaAs-Schicht 23 zusammen. Die einzelnen voneinander getrennten Fotodiodenstrukturen 10 sind dadurch hergestellt, daß diese Schichtenfolge einschließlich der ersten dotierten III-V-Halbleiterschicht 6 entlang von vorgegebenen Trennungslinien beispielsweise mittels Ätzgräben 24 durchtrennt sind. Die Innenseiten der Ätzgräben 24 sind mit einer beispielsweise aus SiO₂ bestehenden Isolationsschicht 25 versehen, auf der wiederum eine Metallisierungsschicht 26 aufgebracht ist, über die die einzelnen Fotodiodenstrukturen 10 seriell miteinander verschaltet sind.

Auch bei dieser Halbleitervorrichtung handelt es sich um ein herkömmliches dem Fachmann bekanntes Halbleiterbauelement und wird von daher an dieser Stelle nicht näher erläutert.

Selbstverständlich kann bei der erfindungsgemäßen Halbleitervorrichtung anstelle des in den Ausführungsbeispielen genannten III-V-Halbleitersubstrats aus GaAs je nach Art der auf das Substrat aufzubringenden funktionellen Halbleiterstruktur auch jedes andere III-V-Halbleitermaterial verwendet werden. Ebenso kann es natürlich auch p-leitend ausgebildet sein. Die erste und die zweite dotierte III-V-Halbleiterschicht sind dann entsprechend anzupassen.

Ein Vorteil von leitenden III-V-Halbleitersubstraten gegenüber semiisolierenden Substraten besteht darin, daß das Kristallzuchtverfahren wesentlich einfacher zu beherrschen ist. Dies führt zu homogeneren Wafern, deren Dotierstoff (im allgemeinen Si) sich zudem durch geringe Diffusionseffekte auszeichnet.

Außerdem können vorteilhafterweise die Dotierstoffe für den oder die pn-Übergänge epitaktisch, beispielsweise mittels MOVPE oder MBE, in das III-V-Kristallgitter eingebaut werden, wodurch eine gegenüber dem Substrat höhere Qualität (geringere Störstellen-Konzentration, geringere Versetzungsdichten usw.) und damit eine wesentlich bessere Temperaturbeständigkeit erzielt wird.

Selbstverständlich ist erfindungsgemäß auch vorgesehen, verschiedenartige funktionelle Halbleiterstrukturen 1, z. B. Photodioden, Leuchtdioden, Transistoren, MCRW-Laserdioden usw., auf ein und demselben elektrisch leitenden III-V-Halbleitersubstrat 3 anzuordnen.

### Bezugszeichenliste

- 1: Funktionelle Halbleiterstruktur
- 3: III-V-Halbleitersubstrat
- 4: pn-Übergang
- 5: pn-Übergang
- 6: erste dotierte III-V-Halbleiterschicht
- 7: zweite dotierte III-V-Halbleiterschicht
- 8: Fotodiodenfeld
- 9: MCRW-Laserstruktur
- 10: Fotodiodenstruktur
- 11: erste Hauptfläche
- 12: zweite Hauptfläche
- 13: Metallisierungsschicht
- 14: n⁺-dotierte GaAs-Schicht
- 15: n-dotierte GaAlAs-Schicht
- 16: aktive Schicht aus undotiertem GaAs
- 17: p-dotierte GaAlAs-Schicht
- 18: p⁺-dotierte GaAs-Schicht
- 19: n-Kontakt
- 20: p-Kontaktmetallisierung
- 21: n-dotierte GaAs-Schicht
- 22: p-dotierte GaAs-Schicht
- 23: p-dotierte AlGaAs-Schicht
- 24: Ätzgraben
- 25: Isolationsschicht
- 26: Metallisierungsschicht

## Patentansprüche

1. Halbleitervorrichtung, bei dem einer ersten Hauptfläche eines III-V-Halbleiter-Substrats (3) mindestens eine funktionelle Halbleiterstruktur (1) zugeordnet ist und bei dem die funktionelle Halbleiterstruktur (1) von einer der ersten Hauptfläche (11) gegenüberliegenden zweiten Hauptfläche (12) des III-V-Halbleiter-Substrats (3) elektrisch isoliert ist,
**dadurch gekennzeichnet,** daß
ein elektrisch leitendes III-V-Halbleiter-Substrat (3) vorgesehen ist und daß zwischen der funktionellen Halbleiterstruktur (1) und der zweiten Hauptfläche des III-V-Halbleiter-Substrats (3) mindestens ein im Betrieb der Halbleitervorrichtung sperrend gepolter pn-Übergang (4,5) vorgesehen ist.

2. Halbleitervorrichtung nach Anspruch 1,
**dadurch gekennzeichnet,** daß
das elektrisch leitende III-V-Halbleiter-Substrat (3) bei Raumtemperatur eine Ladungsträgerkonzentration von größer als 1*10¹⁵ cm⁻³ aufweist.

3. Halbleitervorrichtung nach Anspruch 2,
**dadurch gekennzeichnet,** daß
das elektrisch leitende III-V-Halbleiter-Substrat (3) bei Raumtemperatur eine Ladungsträgerkonzentration zwischen 1*10¹⁶ cm⁻³ und 1*10¹⁹ cm⁻³ aufweist.

4. Halbleitervorrichtung nach einem der Ansprüche 1 bis 3,
**dadurch gekennzeichnet,** daß das III-
V-Halbleiter-Substrat (3) einen ersten Leitungstyp aufweist und daß zwischen dem III-V-Halbleiter-Substrat (3) des ersten Leitungstyps und der funktionellen Halbleiterstruktur (1) eine erste dotierte III-V-Halbleiterschicht (6) eines zweiten Leitungstyps angeordnet ist.

5. Halbleitervorrichtung nach einem der Ansprüche 1 bis 4,
**dadurch gekennzeichnet,** daß
auf dem dotierten III-V-Halbleiter-Substrat (3) eines ersten Leitungstyps eine erste dotierte III-V-Halbleiterschicht (6) eines zweiten Leitungstyps aufgebracht ist und daß auf der ersten dotierten III-V-Halbleiterschicht (6) eine zweite dotierte III-V-Halbleiterschicht (7) vom ersten Leitungstyp aufgebracht ist, derart, daß das III-V-Halbleiter-Substrat (3), die erste (6) und die zweite dotierte III-V-Halbleiterschicht (7) zwei entgegengesetzt gerichtete pn-Übergänge (4,5) ausbilden, auf denen die funktionelle Halbleiterstruktur (1) angeordnet ist.

6. Halbleitervorrichtung nach einem der Ansprüche 1 bis 5,
**dadurch gekennzeichnet,** daß
als funktionelle Halbleiterstruktur (1) eine MCRW-Laserstruktur (9) vorgesehen ist.

7. Halbleitervorrichtung nach einem der Ansprüche 1 bis 5,
**dadurch gekennzeichnet,** daß
als funktionelle Halbleiterstrukturen (1) Photodiodenstrukturen (10) vorgesehen sind, die ein Photodiodenfeld (8) bilden.

8. Halbleitervorrichtung nach einem der Ansprüche 1 bis 7,
**dadurch gekennzeichnet,** daß minde
stens zwei monolithisch integrierte funktionelle Halbleiterstrukturen (1) auf dem elektrisch leitenden III-V-Halbleiter-Substrat (3) vorgesehen sind und daß zwischen jeder der funktionellen Halbleiterstrukturen (1) und der zweiten Hauptfläche (12) des elektrisch leitenden III-V-Halbleiter-Substrat (3) mindestens ein im Betrieb der Halbleitervorrichtung sperrend gepolter pn-Übergang (4,5) angeordnet ist.

9. Halbleitervorrichtung nach Anspruch 8,
**dadurch gekennzeichnet,** daß
der pn-Übergang (4) bzw. die pn-Übergänge (4,5) in einem Zwischenraum zwischen zwei funktionellen Halbleiterstrukturen (1) derart durchtrennt ist bzw. sind, daß über das III-V-Halbleiter-Substrat (3) einschließlich ggf. einer oder mehrerer darauf aufgebrachter III-V-Halbleiterschichten (6,7) keine elektrisch leitende Verbindung zwischen den funktionellen Halbleiterstrukturen (1) besteht.

10. Halbleitervorrichtung nach einem der Ansprüche 1 bis 9,
**dadurch gekennzeichnet,** daß minde
stens zwei verschiedenartige monolithisch integrierte funktionelle Halbleiterstrukturen (1) auf dem elektrisch leitenden III-V-Halbleiter-Substrat (3) vorgesehen sind.

11. Verfahren zum Herstellen einer Halbleitervorrichtung nach einem der Ansprüche 4 bis 10,
**gekennzeichnet** durch die Verfahrensschritte:
a) Herstellen des dotierten III-V-Halbleiter-Substrats (3) vom ersten Leitungstyp,
b) Aufbringen der ersten dotierten III-V-Halbleiterschicht (6) vom zweiten Leitungstyp auf das III-V-Halbleiter-Substrat (3),
c) ggf. Aufbringen der zweiten dotierten III-V-Halbleiterschicht (7) vom ersten Leitungstyp auf die erste dotierte III-V-Halbleiterschicht (6) ,
d) Aufbringen eines aktiven Schichtensystems auf die zweite dotierte III-V-Halbleiterschicht (7) und
e) Herstellen von mindestens zwei elektrisch voneinander isolierten funktionellen Halbleiterstrukturen (1) mittels Durchtrennen des aktiven Schichtensystems einschließlich der ersten (6) und ggf. der zweiten (7) dotierten III-V-Halbleiterschicht.
